# EUROPEAN PATENT APPLICATION

(11) **EP 1 372 190 A1**
(43) Date of publication of application: **17.12.2003**
(21) Application number: 02254190.8
(22) Date of filing: 14.06.2002
(51) Int. Cl.: H01L 21/60, H01L 23/495

(54) **A process for mounting electronic devices onto submounts and submount therefor**

(71) Applicant: Agilent Technologies, Inc. - a Delaware corporation -, Palo Alto, CA 94303-0870 (US)
(72) Inventor: Soldano, Lucas Beda, 10040 Givoletto (TO) (IT); Audino, Roberto, 10036 Settimo Torinese (TO) (IT)
(74) Representative: Coker, David Graeme

(57) **Abstract**

The invention provides a method of soldering an electronic device (LC) onto a submount provided with an electrode track (ET). The method provides for the electronic device to be located onto a mounting area (SP) for the device with the interposition of a soldering mass in the molten state. Subsequent consolidation of the soldering mass results in the device (LC) been retained on the submount. A sculptured pattern (11) of cavities (13) and bridge-like formations (14) is provided in the electronic track (ET) adjacent the mounting area (SP) for the device. The soldering mass in the molten state is thus trapped by surface tension phenomena within the sculptured pattern (11) and is thus prevented from undesirably spilling from the mounting area (SP) for the device over the electrode track (ET) beyond the sculptured pattern (11).

## Description

The invention relates to mounting techniques for electronic devices and was devised by paying specific attention to the possible application to mounting opto-electronic devices such as lasers, photodiodes, amplifiers, modulators onto corresponding submounts.

Such devices are currently mounted onto the substrates intended to support them by soldering, that is by melting a metal alloy (e.g. InPb, SnPb, AuSn, and so on) in the form of a pad deposited or a so-called preform located on an electrode track (typically Au) provided on a submount of ceramic material, silicon or the like.

The captioned technique may give rise to drawbacks primarily related to the tendency of the solder i.e. the soldering mass, when in the molten i.e. fluid state, to spread over the electrode track.

Essentially, those drawbacks are related to the soldering mass being prone to spill over the facets of the device being soldered and to the non-uniform distribution of the solder material with the ensuing risk of undesired device tilting, solder volume creeping and lateral misalignment of the device with respect to the intended mounting position. Also, the solder alloy is exposed to becoming Au-rich and thus prone to the formation of inter-metallic compounds which in turn may lead to reliability problems.

Figure 1 herein shows a AuSn solder pad SP deposited on a conventional electrode track ET provided on a submount; the submount in question is only partly shown in the drawing and is designated SM.

Figure 2, similarly related to the prior art, shows a laser chip LC soldered on a structure as described with reference to figure 1. Solder having spread irregularly away from the soldering area SP and spilled over electrode track ET can be clearly seen as indicated at 10.

In order to prevent such undesired spreading/spilling phenomena, arrangements have been devised in the prior art relying on "barrier" structures in the form of non-wettable metal strips (e.g. Cr) deposited across the electrode track in order to prevent the solder mass from undesirably spreading away from the soldering area. The barrier layers in question must however be deposited and patterned, which involves additional steps in the fabric action process thus increasing run times and lowering yields.

Also, it will be promptly appreciated that the drawbacks outlined in the foregoing, or drawbacks substantially similar thereto, are likely to be encountered in any mounting techniques providing for a device being located on a mounting area of a submount with the interposition of a fixing mass in the fluid (molten) state, whereby subsequent consolidation of the fixing mass results in the device being retained on the submount.

Even though soldering has been and will be primarily referred to in the present description, the scope of the invention is in no way limited to soldering but equally extends to equivalent bonding techniques.

The object of the present invention is thus to provide an improved solution dispensing with the above-captioned drawbacks. According to the present invention such an object is achieved by means of a process having the features set forth in the claims that follow. The invention also relates to a corresponding submount.

In the presently preferred embodiment, the invention provides a method of mounting an electronic device onto a submount provided with an electrode track. The method provides for the electronic device to be located onto a mounting area for the device on the submount with the interposition of a fixing mass such as a soldering mass in the molten state. Subsequent consolidation of the soldering mass results in the device being retained on the submount. A pattern of a "sculptured" nature, being comprised e.g. of cavities (which may be in the form of through holes or pits such as grooves, incisions, etc.) and bridge-like formations is provided in the electronic track adjacent the mounting area for the device. The soldering mass in the molten state is thus trapped by surface tension phenomena in the passages defined between the formations making up the sculptured pattern and is thus prevented from undesirably spilling away from the mounting area for the device over the electrode track beyond the linear pattern.

The invention will now be described, by way of example only, by referring to the enclosed figures of drawing, wherein:

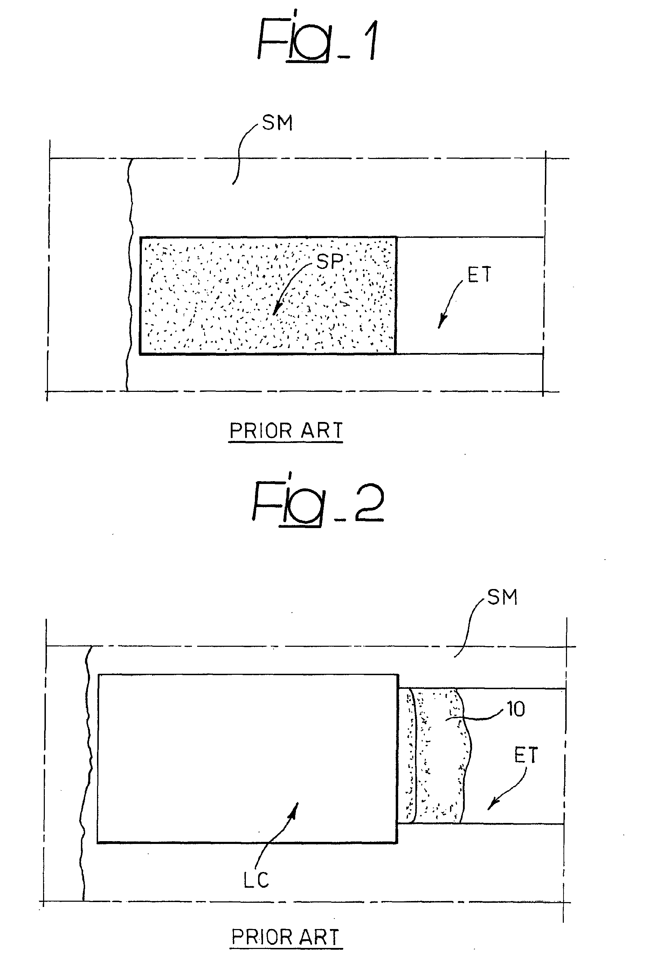

- Figures 1 and 2, related to the prior art, were already described in the foregoing,

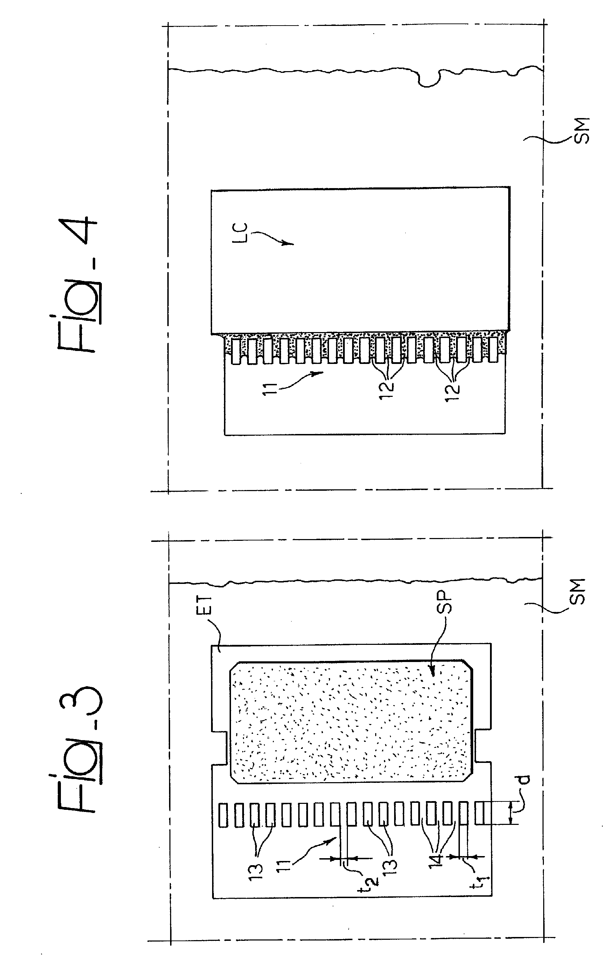

- Figure 3 shows an electrode track adapted for use in the invention, and
- Figure 4 shows an electronic device mounted on the structure shown in figure 3.

In figures 3 and 4 parts/components identical or equivalent to those already described in connection with figures 1 and 2 are indicated with the same references.

Consequently, also in figures 3 and 4 SM indicates a submount of a known type (ceramic, silicon), shown only partly in the drawing and intended for mounting an electronic device such as an optoelectronic device.

An electrode track ET is provided on submount SM. A solder pad SP is provided on electrode track ET, whereby pad SP defines a mounting area for soldering thereon an electronic device typically comprised of an opto-electronic device such as a laser chip LC.

It will be promptly appreciated that the shapes/patterns of the electrode tracks ET and soldering pads SP shown in figures 3 and 4 are different from those shown in figures 1 and 2. Such a difference highlights that the specific patterns/configurations of the elements involved does not per se represent a critical factor for the invention.

In figures 3 and 4, reference numeral 11 designates a string of "fulls" and "voids" (that is a sort of zebra-crossing pattern) realised directly in the electrode material thus providing a "sculptured" pattern defining narrow passages therethrough.

The captioned zebra-crossing pattern is preferably formed during the same process step(s) where electrode track ET is defined. This involves typically a metallization step adapted to be carried out with any current technique known for that purpose for instance in integrated circuit technology. Exemplary of such a technique is vacuum deposition of a thin, even coating of metal (such as Au) over the surface of submount SM and subsequently etching away (by physical and/or chemical means) all the undesired metal areas, leaving the desired pattern of electrode track ET including the sculptured pattern 11.

Alternative techniques (e.g. thin-film or thick-film technology) are well known to those of skill in the art.

The "sculpturing" of pattern 11 creates a relatively dense array of narrow passages over the surface of electrode track ET whose electrical continuity (i.e. conductivity) is preserved.

In the presently preferred embodiment, pattern 11 is comprised of an orderly sequence of square/rectangular holes separated by bridge-like elements defining narrow passages therebetween. Any molten solder mass tending to spread away from the soldering area (namely the area of mounting pad SP onto which device LC is soldered) is prevented from uncontrollably spreading away over electrode track ET due to surface tension phenomena created in such passages of pattern 11. In that way, any such solder mass is precisely and safely "trapped" between such holes as indicated in 12 in figure 4.

The preferred dimensions of holes 13 (which, as an alternative to the through holes shown herein may take the form of pits etched into the upper surface of electrode track ET) and - more to the point - bridge-like passages 14 are related to the surface tension phenomena occurring between the materials comprising electrode track ET and the solder mass.

For instance, in the case of electrode tracks ET comprised of materials such as Al, Au, AuNi, AuCr, AuTi, AuNiTi, AuPtTi, AuPdTi and similar thin film multilayers and soldering masses comprised of metals such as In as well as alloys such as InPb, SnPb, AuSn, SnIn, AgIn, AgPb and AgSn, pattern 11 is typically comprised of a linear (straight or curved) pattern having a typical depth "d" (see figure 3) of the order of 20-60 microns.

Also, it will be appreciated that pattern 11 need not necessarily follow a straight line, since also other trajectories generally surrounding soldering pad SP are included within the scope of the present invention.

By referring to the electrode track and solder mass materials indicated in the foregoing, typical values of the width of holes 13 (t₁ in figure 3), measured in the direction of extension of pattern 11, are in the range of 10 microns, even though this parameter is not particularly critical.

Conversely, the width (t₂ in figure 3) of bridge-like elements 14 must be devised as a judicious trade-off between the need of ensuring proper electrical conductivity of electrode track ET and obtaining the desired "trapping" effect of the soldering mass by surface tension phenomena in the narrow passages defined by bridge-like formations 14 in sculptured pattern 11.

Typical values of t₂ are in the range of a few microns (e.g. 2 microns) to tens of microns (e.g. 20 microns).

Of course, holes (or pits) 13 and bridge-like formations 14 extending therebetween need not be necessarily identical over the entire length of pattern 11. Patterns including holes/pits 13 and bridge-like elements 14 of variable widths along the lengths of pattern 11 are also comprised within the scope of the present invention.

Even in the presence of a fixing mass whose rheological characteristics (density, viscosity, etc...) in the fluid state are not known a priori, those of skill in the art will be in a position to identify by easy experimentation the dimensions of the formations (passages) of pattern 11 for giving rise to the surface tension (capillarity) effect being pursued.

Of course, the underlying principles of the invention remaining the same, the details of construction and the embodiments may widely vary with respect to what has been described and illustrated purely by way of example, without departing from the scope of the present invention, as defined by the annexed claims.

## Claims

1. A method of mounting an electronic device (LC) onto a submount (SM) provided with an electrode track (ET), the method including the step of locating said electronic device (LC) onto a mounting area (SP) for said device on said submount (SM) with the interposition of a fixing mass in the fluid state, whereby subsequent consolidation of said fixing mass (10) results in said electronic device (LC) being retained onto said submount (SM), **characterised in that** it includes the step of providing in said electrode track (ET) a sculptured pattern (11) defining narrow passages (14), said sculptured pattern (11) being adjacent said mounting area (SP), whereby said fixing mass in the fluid state is trapped (12) by surface tension phenomena within said narrow passages (14) and thus prevented from spilling from said mounting area (SP) over said electrode track (ET) beyond said sculptured pattern (11).

2. The method of claim 1, **characterised in that** it includes the step of forming said sculptured pattern as a linear, straight or curved, pattern.

3. The method of claims 1 or 2, **characterised in that** it includes the step of forming said sculptured pattern (11) as a sequence of cavities (13) and bridge-like formations (14) in said electrode track (ET), wherein said bridge-like formations (14) define said narrow passages.

4. The method of claim 3, **characterised in that** said cavities (13) are provided in the form of through holes in said electrode track (ET).

5. The method of claim 3, **characterised in that** said cavities (13) are provided in the form of pits in said electrode track (ET).

6. The method of any of previous claims 1 to 5, **characterised in that** it includes the step of providing said sculptured pattern (11) in said electrode track (ET) while concurrently forming said electrode track (ET) onto said submount (SM).

7. The method of either of claims 1 or 6, **characterised in that** it includes the step of providing said electrode track (ET) having said sculptured pattern (11) as a metallization over said submount (SM).

8. The method of any of the previous claims, **characterised in that** it includes the step of providing said sculptured pattern (11) as a regular pattern of identical formations (13, 14).

9. The method of any of claims 1 to 7, **characterised in that** it includes the step of providing said sculptured pattern (11) as a pattern including formations of varying size along the pattern (11).

10. The method of any of the previous claims, **characterised in that** said linear pattern (11) has a width (d) across said pattern (1), said width (d) being in the range of 20 to 60 microns.

11. The method of claim 3, **characterised in that** said cavities (13) have a dimension (t₁) in the direction of said pattern in the range of 10 microns.

12. The method of either of claims 3 or 11, **characterised in that** said bridge-like formations (14) have a dimension (t₂) in the direction of said pattern in the range of a few microns to tens of microns, preferably 2 to 20 microns.

13. The method of any of the previous claims, **characterised in that** said electrode track (ET) is comprised of a metal.

14. The method of claim 13, **characterised in that** said electrode track (ET) is comprised of a material selected from the group consisting of Al, Au, AuNi, AuCr, AuTi, AuNiTi, AuPtTi, AuPdTi.

15. The method of any of the previous claims, **characterised in that** said fixing mass is a soldering mass comprised of a metal or metal alloy.

16. The method of claim 15, **characterised in that** said soldering mass is comprised of a material selected from the group consisting of In,InPb, SnPb, AuSn, SnIn, AgIn, AgPb, AgSn.

17. A submount (SM) for mounting an electronic device (LC) thereon, said submount including a mounting area (SP) for said device (LC) and an electrode track (ET), **characterised in that** said electrode track (ET) is provided with a sculptured pattern (11) defining narrow passages (14), said sculptured pattern (11) being adjacent said mounting area (SP) and adapted to trap by surface tension phenomena in said narrow passages (14) any fixing mass in the fluid state for said device (LC), thus preventing said fixing mass from undesirably spilling from said mounting area (SP) over said electrode track beyond said sculptured pattern (11).

18. The submount of claim 17, **characterised in that** said sculptured pattern is a linear, straight or curved, pattern.

19. The submount of either of claims 17 or 18, **characterised in that** said sculptured pattern (11) includes a sequence of cavities (13) and bridge-like formations (14) in said electrode track (ET), wherein said bridge-like formations (14) define said narrow passages.

20. The submount of claim 19, **characterised in that** said cavities (13) are in the form of through holes in said electrode track (ET).

21. The submount of claim 19, **characterised in that** said cavities (13) are in the form of pits in said electrode track (ET).

22. The submount of any of claims 17 to 21, **characterised in that** said electrode track (ET) having said pattern (11) is a metallization over said submount (SM).

23. The submount of any of claims 17 to 22, **characterised in that** said sculptured pattern (11) is a regular pattern of identical formations (13, 14).

24. The submount of any of claims 17 to 22, **characterised in that** said sculptured pattern includes a pattern of formations (13, 14) different in size along the pattern (11).

25. The submount of any of claims 17 to 24, **characterised in that** said pattern (11) has a width (d) across said linear pattern (1), said width (d) being in the range of 20 to 60 microns.

26. The submount of claim 19, **characterised in that** said cavities (13) have a dimension (t₁) in the direction of said linear pattern in the range of 10 microns.

27. The submount of either of claims 19 or 26, **characterised in that** said bridge-like formations (14) have a dimension (t₂) in the direction of said pattern in the range of a few microns to tens of microns, preferably 2 to 20 microns.

28. The submount of any of claims 17 to 27, **characterised in that** said electrode track (ET) is comprised of a metal.

29. The submount of claim 28, **characterised in that** said electrode track (ET) is comprised of a material selected from the group consisting of Al, Au, AuNi, AuCr, AuTi, AuNiTi, AuPtTi, AuPdTi.
